# FASCICULE DE BREVET EUROPEEN

(11) **EP 2 378 849 B1**
(45) Date de publication et mention de la délivrance du brevet: **05.06.2013**
(21) Numéro de dépôt: 11162072.0
(22) Date de dépôt: 12.04.2011
(51) Int. Cl.: H05K 7/14

(54) **Ensemble modulaire de fixation de modules électroniques**
Modulbaugruppe zum Befestigen von elektronischen Modulen
Modular assembly for mounting electronic modules

(30) Priorité: 13.04.2010 FR 1052795
(43) Date de publication de la demande: 19.10.2011
(73) Titulaire: Airbus Operations, 31060 Toulouse (FR)
(72) Inventeur: Salles, Pierre, 31880, La Salvetat St Gilles (FR)
(74) Mandataire: Petit, Maxime

(56) Documents cités:
- EP-A1- 1 958 490
- WO-A1-2010/046376
- US-A- 5 148 353
- US-A1- 2004 050 569

## Description

La présente invention concerne un ensemble modulaire pour la fixation mécanique de modules électroniques.

Dans un aéronef, de nombreux équipements électroniques sont localisés dans une zone située sous le cockpit de l'aéronef, qui offre aux équipements des conditions environnementales privilégiées telles qu'une pression ambiante raisonnable et une température ambiante maîtrisée. Des meubles sont disposés dans cette zone et permettent de fixer les équipements, de les connecter aux câbles de l'aéronef et de les ventiler.

Le document US2004050569 décrit et représente un ensemble de connexion connu, dans lequel au moins un équipement électronique est disposé dans un moyen de support. Ce moyen de support comprend une structure porteuse mobile en forme générale de chaise ayant un support horizontal, un élément de fond vertical et deux montants latéraux, cette structure définissant un logement pour recevoir un équipement électronique. La structure porteuse comprend une interface de connexion au niveau de l'élément de fond et sur laquelle vient se connecter horizontalement l'équipement électronique. L'ensemble ainsi formé est amené dans la zone souhaitée, à côté d'autres ensembles formés séparément et le câblage de l'aéronef est rapporté sur chaque interface de connexion solidaire d'un équipement électronique,

Le document WO 20101046376 décrit une structure de fixation d'un composant d'équipement d'aéronef qui comporte un.support à base en V et des structures de fixation formant un cadre auquel peut être suspendu le composant.

Un tel ensemble est notamment défini par la norme aéronautique internationale ARINC 600.

Ce type d'ensemble pourrait toutefois être amélioré en fonction de solutions futures plus modulaires.

L'invention propose à cet égard un nouvel ensemble modulaire de fixation de module(s)/équipements(s) électronique(s),

L'invention a plus particulièrement pour objet un ensemble modulaire de fixation de modules électroniques embarqués à bord d'un aéronef, caractérisé en ce qu'il comprend :
- un cadre sensiblement plan comportant au moins deux montants longitudinaux reliés entre eux par une pluralité de montants transversaux ayant une surface frontale verticale sensiblement plane, comprenant plusieurs interfaces de fixation mécanique destinées à fixer mécaniquement chacune un module électronique et plusieurs interfaces de connexion électrique destinées à établir chacune une connexion électrique avec un module électronique,
- au moins un module électronique comprenant, sur sa face arrière, une interface de fixation mécanique et qui est accroché à la surface frontale du cadre en position suspendue par coopération de l'interface de fixation mécanique dudit au moins un module électronique avec l'une des interfaces de fixation mécanique du cadre et une interface de connexion électrique coopérant avec l'une des interfaces de connexion électrique du cadre afin d'établir une connexion électrique

Cet ensemble est modulaire en ce sens qu'il peut accueillir sur le cadre plusieurs modules électroniques de différentes largeurs. La largeur d'un module correspond à une dimension horizontale parallèle à la surface frontale verticale lorsque le cadre est installé verticalement et que le module est suspendu. Le cadre peut notamment avoir une épaisseur variable ou comporter une partie non plane.

En particulier, les interfaces de connexion mécanique peuvent être situées à l'arrière du module électronique ou sur les flancs de ce dernier. D'autres configurations peuvent également être envisagées.

L'ensemble selon l'invention est de conception plus simple que les ensembles connus de l'art antérieur.

L'accrochage d'un module sur une surface verticale du cadre en le suspendant à cette dernière permet de réduire l'encombrement global de l'ensemble.

En effet, le module est amené contre la surface frontale au-dessus de la position d'accrochage, puis est abaissé jusqu'à ce que le système d'accrochage du module s'engage avec l'un des systèmes d'accrochage du cadre et que le module soit retenu par ce dernier en position suspendue.

Il n'est donc plus nécessaire, au moins dans certains cas, de disposer de la longueur ou profondeur totale du module devant l'ensemble de fixation et de connexion pour pouvoir installer le module en position sur le cadre et l'en retirer.

Par ailleurs, le fait que le module soit suspendu à un cadre est avantageux dans la mesure où la masse du module est une aide à la fixation. En effet, le poids du module a tendance à rapprocher celui-ci de la surface frontale du cadre et par exemple à le plaquer contre celui-ci dès lors qu'il est engagé dans l'un des moyens d'accrochage par suspension. Cette facilité d'accrochage du module est avantageuse dans des espaces confinés de l'aéronef. En outre, la structure d'accueil des modules est constituée du cadre qui occupe moins de place en épaisseur ou en profondeur que les meubles de l'art antérieur même en l'absence de modules.

De plus, lorsque les modules sont suspendus au cadre ils ne sont pas séparés les uns des autres par des cloisons latérales qui sont susceptibles de réduire l'espace disponible pour accueillir les modules.

Lorsque les modules sont suspendus il n'y a pas non plus de cloisons supérieure ou inférieure.

Ainsi, les modules ne sont pas confinés, ce qui favorise les échanges thermiques avec l'air ambiant.

On notera que l'ensemble modulaire brièvement exposé ci-dessus s'applique aussi bien à des modules électroniques qui sont autonomes électriquement qu'à des modules électroniques qui ne le sont pas

Le système d'accrochage d'un module par suspension permet de tirer profit du poids de ce dernier. Ainsi, le poids du module tend à plaquer celui-ci contre la surface frontale du cadre et notamment contre l'interface de connexion électrique, favorisant donc l'établissement de la connexion électrique.

Dès lors qu'un module est suspendu au cadre et en contact avec la surface frontale de celui-ci les interfaces de connexion électrique respectives agencées le long de la surface frontale sont en contact mécanique et électrique l'une avec l'autre.

L'interface de connexion électrique du cadre est reliée par exemple au câblage de l'installation et notamment au câblage d'un aéronef dans lequel l'ensemble peut être implanté.

On notera que lorsque l'interface de connexion électrique est une interface de type connectique à pistons elle constitue une aide « naturelle » à la déconnexion des modules.

En effet, lorsque l'on écarte le module de la surface frontale du cadre et donc de l'interface de connexion du cadre les ressorts des contacts à pistons contribuent également à cet écartement et, donc, au désengagement du module,

Les avantages précités sont particulièrement intéressants lorsque l'ensemble est implanté dans un aéronef.

Selon une caractéristique le module possède une dimension qui s'étend entre deux extrémités opposées et qui est disposée verticalement lorsque le module est accroché au cadre, le module étant accroché à la surface frontale du cadre à proximité de l'extrémité haute.

Selon une caractéristique, l'ensemble comporte des moyens de verrouillage du module en position suspendue.

Le verrouillage des modules sur le cadre offre une sécurité supplémentaire et assure également une fixation supplémentaire.

Plus particulièrement, les moyens de verrouillage (mécanisme de verrouillage) sont disposés en partie sur le cadre et en partie sur le module et coopèrent par un engagement des moyens de verrouillage du module avec les moyens complémentaires du cadre.

Selon une caractéristique, les moyens de verrouillage du module comprennent une partie assujettie au module à proximité de l'extrémité opposée basse.

Ainsi, le module est amené le long de la surface frontale du cadre au-dessus de la position d'accrochage prévue et est abaissé de manière à engager le système d'accrochage de l'extrémité haute avec le système d'accrochage complémentaire de la surface frontale du cadre. Ensuite, lorsque des moyens de verrouillage sont disposés au voisinage de l'extrémité basse du module, ils sont enclenchés avec les moyens de verrouillage complémentaires de la surface frontale du cadre.

Le module se trouve alors fixé par au moins deux points d'ancrage en haut et en bas, contre la surface frontale du cadre, empêchant ainsi le module de s'écarter du cadre en cas de mouvements du véhicule (exemple: aéronef) transportant l'ensemble ou de vibrations transmises à l'ensemble.

Un tel écart risquerait en effet d'affecter les connexions électriques module - cadre.

Selon une caractéristique, un organe d'actionnement relié aux moyens de verrouillage est prévu sur le module et est actionnable entre une position verrouillée dans laquelle l'organe est disposé contre le module et une position déverrouillée dans laquelle l'organe est écarté du module.

Cet organe de sécurité fait par exemple office de témoin visuel. Lorsque l'organe est en position écartée du module il peut être vu par un observateur qui en déduit alors que le module n'est pas fixé de manière verrouillée sur le cadre. On notera que la position écartée est définie suivant une vue dans un plan perpendiculaire à la surface frontale du cadre.

Selon une caractéristique, le module est accroché à la surface frontale du cadre par l'intermédiaire d'un système d'accrochage formant une liaison articulée.

Ce système d'accrochage assure un rôle de guidage du module lors de la phase d'accrochage et notamment d'articulation par rapport au cadre.

Le module est ainsi articulé par rapport au cadre par exemple par une liaison de type charnière.

Lorsque les moyens de verrouillage (optionnels) ne sont pas enclenchés le module peut ainsi être écarté du cadre par pivotement autour de sa liaison charnière avec ledit cadre.

La mise en place du module est ainsi, par exemple, effectuée en amenant le module en position inclinée (pivotée) par rapport au cadre afin d'engager par le dessus le système d'accrochage du module sur le système d'accrochage complémentaire du cadre, puis en faisant pivoter le module autour de la liaison charnière en l'amenant au contact de la surface frontale du cadre.

On notera que le système d'accrochage par liaison articulée peut alternativement être agencé en partie basse du module.

Le système d'accrochage par liaison articulée comprend par exemple un système de pivot/crochet, le(s) crochet(s) pouvant être sur le module et le(s) pivot(s) sur le cadre ou inversement.

Il est par exemple envisageable de placer le pivot sur le module afin d'éviter de manipuler un équipement avec une forme « agressive » pour des raisons de sécurité des personnes.

D'autres systèmes d'accrochage/guidage sont envisageables tels que des systèmes à coulissement. Le coulissement pourrait s'effectuer parallèlement à la surface frontale du cadre ou perpendiculairement à celle-ci sur une courte distance (par exemple via des rails de quelques centimètres de longueur).

Un système d'accrochage combinant une liaison articulée et un coulissement perpendiculairement à la surface frontale du cadre pourrait être utilisé avec une interface de connexion électrique nécessitant l'emboîtement de contacts électriques mâles et femelles.

Selon une caractéristique, l'ensemble comprend un système de climatisation ou de gestion thermique du module électronique.

Ce système lié au cadre est par exemple destiné à refroidir le module, sur commande, lorsque celui-ci est accroché au cadre.

Selon une caractéristique, le système de climatisation comprend, fixées au cadre, une unité d'injection d'un fluide (par exemple de refroidissement) dans le module et une unité d'aspiration du fluide ayant été injecté dans le module et/ou une ouverture dans le module pour l'évacuation du fluide injecté. Le module comporte une interface complémentaire pour coopérer avec au moins l'unité d'injection.

La ou les ouvertures d'évacuation de fluide (air) peuvent être agencées sur le dessus du module et/ou sur la face en contact avec la surface frontale du cadre.

Le système de climatisation assure ici par exemple une fonction de refroidissement.

Dans l'ensemble modulaire selon l'invention les modules électroniques peuvent être plus proches les uns des autres latéralement que dans l'art antérieur. En effet, le système d'insertion/d'extraction des modules est simplifié du fait du mode d'accrochage par un ou plusieurs points de suspension et nécessite donc moins de place pour l'insertion et l'extraction des modules.

En outre, la gestion thermique module par module permet également de climatiser chaque module efficacement de façon interne. Les modules n'ont donc pas besoin d'être écartés les uns des autres pour échanger thermiquement avec l'air ambiant de la zone et éviter les couplages thermiques entre modules.

La mise en place du module sur le cadre à l'emplacement approprié permet de connecter les unités d'injection et d'aspiration du cadre avec les interfaces complémentaires respectives du module. Le cadre comprend par exemple plusieurs caissons ou canaux dans l'épaisseur du cadre et à l'intérieur desquels circulent le fluide de refroidissement qui est amené aux modules et le fluide qui est évacué des modules.

On notera que le système de climatisation comprend, en plus des caissons/canaux, une interface de refroidissement qui est disposée entre les caissons/canaux et l'interface complémentaire du module.

Plus particulièrement, l'interface de climatisation comprend un ou plusieurs orifices/conduits d'amenée ou d'évacuation (selon le type d'interface) de fluide et le module accroché comprend des orifices situés en vis-à-vis et qui sont fixés de façon étanche aux orifices/conduits correspondants de l'interface (par exemple par emboîtement d'un conduit dans l'autre et en utilisant également un joint d'étanchéité) pour permettre la circulation interne de fluide.

On notera que la longueur des conduits d'amenée et d'évacuation (perpendiculaire à la surface frontale du cadre) peut être ajustée pour servir de guidage à un module lors d'une phase de coulissement qui a lieu sur une courte distance et qui est prévue pour l'accrochage du module.

Selon une caractéristique, le cadre comprend un bloc d'interfaçage avec ledit au moins un module qui possède la surface frontale verticale sensiblement plane, le module étant accroché à la surface frontale verticale du bloc d'interfaçage du cadre.

Selon une caractéristique, le bloc d'interfaçage comporte une interface de connexion électrique.

Ce bloc d'interfaçage est ainsi préalablement fixé à la structure du cadre et comporte l'interface de connexion mécanique (système d'accrochage) et éventuellement l'interface de connexion électrique et l'interface de climatisation (exemple : refroidissement) du système de climatisation lorsqu'un tel système est prévu.

Le cadre peut ainsi être réalisé a minima dans une version de base avec des montants horizontaux et verticaux espacés les uns des autres. Des blocs d'interfaçage destinés chacun à s'interfacer mécaniquement et éventuellement électriquement avec un module électronique sont rapportés de façon modulaire sur le cadre en fonction des modules à accueillir.

Chaque bloc a ainsi une largeur qui dépend de celle du module à recevoir.

On notera qu'un bloc d'interfaçage suffisamment large permet d'accrocher plus d'un module électronique.

Selon une caractéristique le cadre comprend une pluralité d'éléments de support horizontaux disposés les uns au-dessus des autres de façon parallèle et espacée, le bloc d'interfaçage étant fixé sur deux éléments de support consécutifs.

Chaque bloc d'interfaçage est ainsi disposé dans l'espace ménagé entre deux éléments de support horizontaux consécutifs et entre les deux éléments de support verticaux qui ferment la structure et définissent son épaisseur.

Chaque bloc est agencé de façon à avoir une épaisseur plus grande dans sa partie centrale que près de deux bords opposés encadrant celle-ci et qui sont amincis, permettant ainsi de loger cette partie centrale épaisse dans l'espace libre mentionné ci-dessus.

L'adjonction des blocs d'interfaçage sur le cadre ne rajoute donc que très peu d'épaisseur au cadre, offrant ainsi un encombrement relativement réduit.

On notera que la partie centrale de chaque bloc loge par exemple l'interface de connexion électrique du bloc.

Selon une caractéristique, l'ensemble comprend une pluralité de systèmes d'accrochage de module qui sont agencés, d'une part, horizontalement pour pouvoir suspendre plusieurs modules les uns à côté des autres suivant une disposition horizontale formant une rangée et, d'autre part, à des cotes verticales différentes de façon à pouvoir suspendre plusieurs rangées de modules les unes au-dessus des autres.

Le cadre de l'ensemble selon l'invention peut ainsi accueillir plusieurs rangées de modules électroniques les unes disposées au-dessus des autres.

L'espace laissé libre en hauteur entre deux rangées consécutives doit être suffisant pour pouvoir installer et retirer un module sans avoir besoin de retirer le ou les modules du dessus mais ne doit pas être trop grand afin de ne pas augmenter considérablement l'encombrement de l'ensemble (notamment sa hauteur).

A cet égard, on notera que la forme des modules peut également contribuer à faciliter l'installation et le retrait des modules.

Ainsi, par exemple chaque module a une forme générale élargie à sa partie en contact avec le cadre et plus étroite à sa partie opposée en suivant une direction perpendiculaire à la surface frontale du cadre.

L'invention a également pour objet un cadre de fixation de modules électroniques embarqués à bord d'un aéronef, caractérisé en ce qu'il est sensiblement plan et en ce qu'il comporte :
- au moins deux montants longitudinaux reliés entre eux par une pluralité de montants transversaux,
- une surface frontale sensiblement plane,
- plusieurs interfaces de fixation mécanique sur la surface frontale destinées chacune à l'accrochage en position suspendue d'un module électronique embarqué à bord de l'aéronef, et
- plusieurs interfaces de connexion électrique destinées à établir chacune une connexion avec un module électronique.

Un tel cadre présente les mêmes avantages que ceux exposés précédemment.

Il peut être installé dans des endroits (locaux...) exigus où l'accès est difficile pour la manipulation des modules électroniques.

Il peut par exemple être installé dans un aéronef et plus particulièrement dans la baie avionique située sous le cockpit.

Selon d'autres caractéristiques du cadre prises isolément ou en combinaison :
- le cadre comporte un système de climatisation du module électrique comprenant une unité d'injection d'un fluide destinée à injecter un fluide de (par exemple de refroidissement) dans le module et éventuellement une unité d'aspiration du fluide destinée à aspirer le fluide ayant été injecté dans le module et l'ayant par exemple refroidi);
- le cadre comporte plusieurs interfaces de connexion électrique destinées chacune à établir une connexion électrique avec un module électronique.
- le cadre comprend des moyens de verrouillage associés au cadre et qui sont destinés à verrouiller le module en position suspendue.

L'invention a aussi pour objet un module électronique destiné à coopérer avec le cadre brièvement exposé ci-dessus.

Ce module d'un nouveau type comporte isolément ou en combinaison:
- une interface de fixation mécanique (système d'accrochage) complémentaire de celle du cadre afin de pouvoir s'accrocher en position suspendue à la surface frontale dudit cadre ;
- une interface de connexion électrique destinée à coopérer avec l'une des interfaces de connexion électrique du cadre pour établir une connexion électrique.

Le module présente les mêmes avantages que ceux déjà exposés ci-dessus.

Selon d'autres caractéristiques du module prises isolément ou en combinaison :
- le module comporte une interface de climatisation complémentaire du système de climatisation du cadre précité et qui est destinée à coopérer avec au moins l'unité d'injection dudit système de refroidissement (on notera que le module peut comporter une ou plusieurs ouvertures pour l'évacuation du fluide injecté);
- le module comprend des moyens de verrouillage du module qui sont complémentaires des moyens de verrouillage associés au cadre précité et qui sont destinés à verrouiller le module en position suspendue sur le cadre.

Par ailleurs, un organe d'actionnement (exemple : poignée) relié aux moyens de verrouillage est prévu sur le module et est actionnable entre une position verrouillée dans laquelle l'organe est disposé contre le module et une position déverrouillée dans laquelle l'organe est écarté du module.

Selon un autre aspect, l'invention vise un aéronef qui comporte un ou plusieurs ensembles modulaires de fixation tels que brièvement exposés ci-dessus.

Selon encore un autre aspect, l'invention vise un aéronef qui comporte un ou plusieurs cadres de fixation tel que brièvement exposé ci-dessus. Ce ou ces cadres servent à accueillir les modules électroniques équipés de moyens de fixation et complémentaires.

D'autres caractéristiques et avantages apparaitront au cours de la description qui va suivre, donnée uniquement à titre d'exemple non limitatif et faite en référence aux dessins annexés, sur lesquels:
- la Figure 1 est une vue schématique générale en perspective d'un cadre selon l'invention comprenant un bloc d'interfaçage;
- la Figure 2 est une vue schématique générale en perspective d'un bloc d'interfaçage destiné à être fixé au cadre tel que représenté à la Figure 1 ;
- la Figure 3 montre une vue schématique en coupe transversale d'un cadre équipé d'un module électronique selon l'invention par l'intermédiaire d'un bloc d'interfaçage;
- les Figures 4a et 4b illustrent de façon schématique différents éléments d'interface électrique destinés à établir une connexion électrique entre le cadre et un module électronique ;
- la Figure 5 illustre de façon schématique un bloc d'interfaçage du module;
- la Figure 6 est une vue schématique en perspective analogue à celle de la Figure 1 et sur laquelle plusieurs blocs d'interfaçage ont été représentés sur le cadre ;
- la Figure 7 illustre de façon schématique la mise en place d'un module électronique sur un cadre selon l'invention ;
- la Figure 8 illustre suivant une perspective en vue de dessous la mise en place d'un module électronique sur un cadre selon l'invention;
- la Figure 9 est une vue schématique en coupe transversal d'un ensemble modulaire selon l'invention;
- la Figure 10 est une vue schématique de face de l'ensemble de la Figure 9 ;
- la Figure 11 est une représentation schématique d'un ensemble modulaire selon l'invention implanté dans un aéronef.

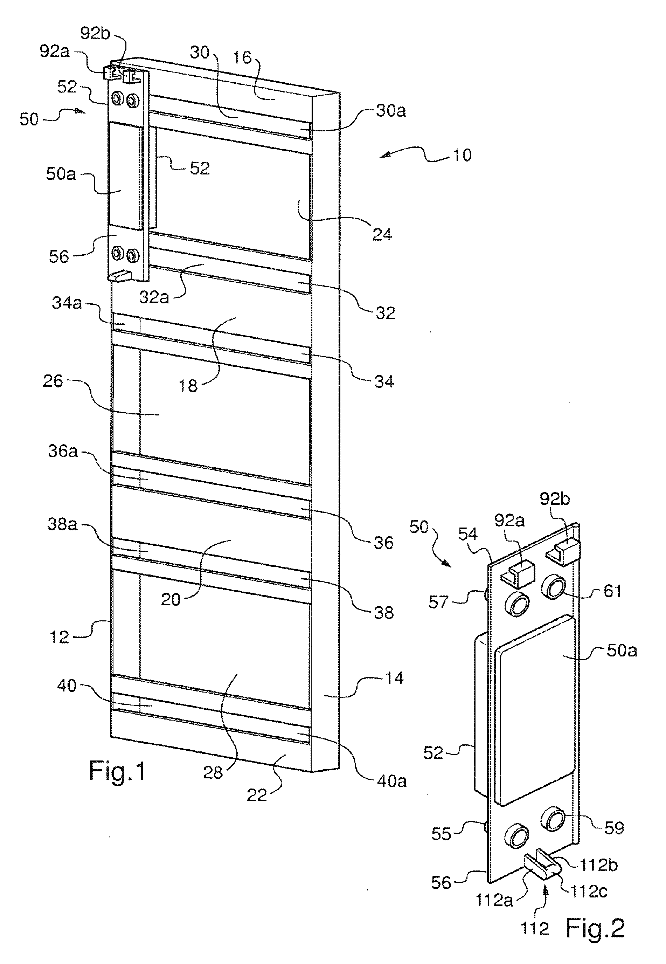

Comme représenté à la Figure 1 et désigné par la référence générale notée 10, un cadre pour la fixation et la connexion électrique de modules ou d'équipements électroniques comprend une structure formée de plusieurs montants longitudinaux et transversaux.

Ce cadre est disposé verticalement pour son utilisation.

Le cadre 10 comprend par exemple deux montants longitudinaux, 12, 14 reliés perpendiculairement entre eux par une pluralité de montants ou éléments de supports transversaux, 16, 18, 20 et 22 parallèles entre eux et écartés des uns des autres afin de ménager un espace libre 24, 26 et 28 entre deux éléments consécutifs.

Les montants longitudinaux 12 et 14 qui, dans l'agencement de la Figure 1, sont représentés en position verticale, sont dotés d'une certaine épaisseur qui définit l'épaisseur totale du cadre 10. Cette épaisseur est ici constante mais peut varier, de même que pour les montants transversaux. Alternativement, les montants longitudinaux ou transversaux peuvent comporter une partie non plane.

L'espace laissé libre 24, 26 et 28 entre deux montants transversaux consécutifs s'étend suivant toute l'épaisseur du cadre et suivant une dimension longitudinale ou hauteur correspondant à l'écartement entre les montants transversaux consécutifs.

Cet espace est très utile comme on le verra par la suite puisqu'il définit un logement à l'intérieur duquel vont être agencés différents éléments selon l'invention permettant d'utiliser le plus efficacement possible le volume disponible.

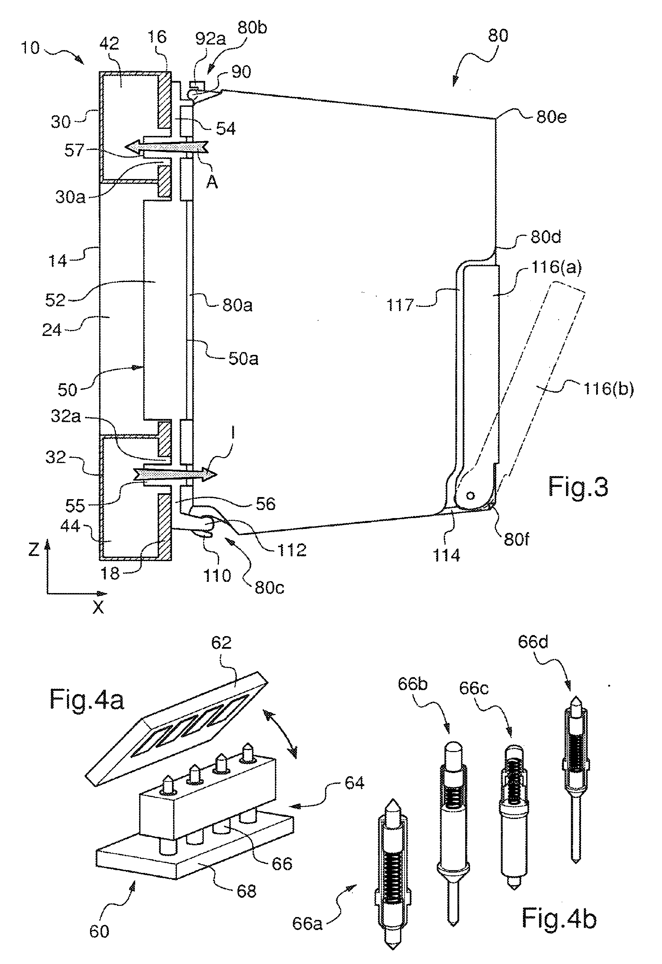

Comme représenté sur la Figure 1 et de façon plus détaillée sur la Figure 3, le cadre 10 comprend plusieurs caissons transversaux creux 30, 32, 34, 36, 38 et 40 agencés chacun derrière les montants transversaux, de façon à former à l'intérieur un canal pour la circulation d'un fluide de refroidissement.

La Figure 3 illustre les caissons supérieur 30 et inférieur 32 à l'intérieur desquels sont formés les canaux de circulation de fluide 42 et 44.

On notera que chaque caisson est raccordé à une amenée et à une évacuation de fluide (non représentées sur les figures).

L'épaisseur des caissons est par exemple égale à l'épaisseur ou la profondeur des montants longitudinaux 12 et 14 et, ainsi, l'épaisseur du cadre est définie par la profondeur des caissons (dimension prise suivant l'axe X) et l'épaisseur des montants transversaux.

La structure du cadre est dimensionnée pour supporter le poids d'une pluralité de modules électroniques qui vont y être suspendus.

Comme représenté sur les Figures, le cadre 10 représente une structure ou armature composée d'un nombre réduit d'éléments/pièces qui sont agencés de façon judicieuse les uns par rapport aux autres afin de pouvoir recevoir des éléments d'équipements du cadre selon l'invention.

Le faible nombre d'éléments/pièces constituant le cadre confère une masse relativement faible, ce qui est avantageux en terme de masse embarquée à bord d'un aéronef.

La structure du cadre est par exemple réalisée en alliage d'aluminium, voire en matériau composite (densité plus faible qu'un alliage d'aluminium). Le choix de ces matériaux pour réaliser le cadre relève de contraintes telles que la mise en forme, la tenue mécanique, la masse et le coût.

La version de base du cadre est donc particulièrement simple et offre une grande modularité comme on le verra par la suite.

En effet, les différents éléments qui vont équiper le cadre peuvent être configurés comme on le souhaite, sans remettre en cause la conception du cadre.

On va maintenant décrire en relation avec les Figures 1 à 3, un élément appelé bloc d'interfaçage, représenté par la référence 50, et qui équipe le cadre 10 afin de pouvoir accueillir un module électronique, voire plusieurs modules électroniques selon l'invention. Un module ou équipement électronique comprend de façon générale une ou plusieurs cartes électroniques disposées à l'intérieur d'un boîtier/capotage ou d'une enceinte de protection et qui comporte une ou plusieurs interfaces de fixation mécaniques et éventuellement une interface de connexion électrique.

Un tel module peut être utilisé comme un calculateur dédié par exemple à une fonction spécifique (par exemple un calculateur de commande de vol) ou comme une ressource.

En tant que ressource un tel module peut constituer une composante d'un calculateur ou une composante servant à plusieurs calculateurs.

De façon plus particulière, le ou les cartes électroniques peuvent comporter différentes fonctionnalités : alimentation, calcul (CPU), entrées/sorties, gestion de bus, mémoires, périphériques particuliers tels que gyromètre, gyroscope, disque dur...

Un module électronique selon l'invention est un élément unitairement remplaçable.

Le bloc d'interfaçage 50 est destiné à être interposé entre le cadre et un module électronique ou bien plusieurs modules électroniques destinés à être fixés et connectés électriquement à ce dernier.

On notera à cet égard que des éléments de connexion électrique non représentés sont prévus. Dans l'exemple illustré sur les Figures où le cadre est installé dans un aéronef, ces éléments sont des faisceaux de câbles de l'aéronef équipés de connecteurs électriques.

Le bloc d'interfaçage 50 présente (Figures 2 et 3) une partie centrale épaisse 52 à partir de laquelle s'étendent dans deux directions opposées des bords ou ailes minces 54 et 56.

Le bloc 50 est installé sur la paroi frontale verticale du cadre, et plus particulièrement sur deux montants transversaux 16 et 18 consécutifs, de façon à ce que la partie centrale épaissie 52 pénètre au moins en partie à l'intérieur de l'espace ou évidement 24 et que les bords ou ailes amincis 54 et 56 soient positionnés contre les montants 16 et 18.

Le bloc d'interfaçage 50 ainsi agencé laisse apparaître vis-à-vis de l'extérieur une surface frontale verticale 50a sur laquelle vont venir se positionner un ou plusieurs modules électroniques selon l'invention.

Les bords ou ailes amincis 54 et 56 du bloc 50 sont respectivement fixés aux montants 16 et 18 par des moyens de tenue mécanique classiques tels que des vis, rivets, boulons, soudage, ou par des moyens de fixation non démontables tels que par soudage, collage ... On notera que le cadre 10 constitue l'infrastructure sur laquelle une pluralité de blocs d'interfaçage analogues au bloc 50 vont être fixés. Ces blocs comportent tous les éléments d'interfaçage nécessaires pour recevoir les modules électroniques selon l'invention.

L'utilisation de blocs d'interfaçage simplifie considérablement la mise en position et la fixation de modules/équipements électroniques sur le cadre. En outre, un bloc d'interfaçage possède une taille réduite par rapport aux systèmes de fixations et aux différentes interfaces utilisés dans l'art antérieur.

Dans l'exemple de réalisation illustré sur les Figures 1 à 3 le bloc d'interfaçage 50 comporte :
- une interface mécanique pour l'accrochage d'un ou de plusieurs modules électroniques le long de la surface frontale 50a du bloc,
- une interface de connexion électrique afin d'établir une connexion électrique avec le ou les modules électroniques précités,
- une interface de climatisation pour permettre la circulation d'un fluide par exemple de refroidissement entre le cadre et le ou les modules électroniques concernés (dans d'autres exemples de réalisation le fluide peut être utilisé pour chauffer un module).

On notera que l'interface d'accrochage d'un module électronique est configurée pour que ledit module soit accroché en étant suspendu au bloc d'interfaçage vertical là où, classiquement, les modules électroniques reposent sur des supports horizontaux et sont encadrés par deux cloisons/montants latéraux. Sur les Figures, les interfaces d'accrochage sont situées à l'arrière du module électronique, mais dans un mode de réalisation alternatif (non représenté), elles sont situées sur les flancs du module électronique. La partie centrale 52 du bloc d'interfaçage comprend une ou plusieurs interface de connexion électrique, par exemple, du type contacts à piston tels que représentés sur les Figures 4a et 4b.

La Figure 4a illustre de façon schématique le principe de l'établissement d'une connexion électrique par des contacts à piston.

Comme représenté sur la Figure 4a, un tel système de connexion particulièrement simple comprend une partie femelle 62 comprenant des zones métallisées, par exemple dorées, sur un circuit imprimé et une partie mâle 64 comprenant une pluralité de contacts à piston 66. Ces contacts sont destinés à venir en contact avec des zones métallisées d'un circuit imprimé 68 lorsque la partie femelle 62 vient au contact de la partie mâle 64 et appuie sur les contacts saillants de cette dernière.

On a représenté sur la Figure 4b plusieurs types de contacts mâles à piston 66a, 66b, 66c et 66d réalisés en deux parties, à savoir une partie mobile (appelée le piston) qui est reliée à l'autre partie fixe du contact mâle par un ressort.

Une collerette ou un fourreau de sertissage est en outre prévu pour sertir le contact mâle sur un faisceau de câbles (câblage) de l'aéronef.

Lors du contact entre la partie femelle et la partie mâle le piston du contact mâle compresse le ressort et entre en contact avec la partie fixe du contact mâle, établissant ainsi la connexion électrique souhaitée.

On notera que dans l'exemple représenté sur les Figures 1 à 3 la partie 52 du bloc comprend par exemple les contacts électriques mâles qui sont plus complexes à réaliser que les contacts femelles, tandis que le module électronique qui sera décrit par la suite comporte la partie pourvue des contacts femelles.

Cet agencement permet de simplifier la structure des modules ou des blocs d'interfaçage des modules.

L'agencement inverse (contacts mâles sur le module et contacts femelles sur le bloc d'interfaçage lié au cadre) est également envisageable et permet de protéger plus facilement les contacts mâles des agressions externes.

Ainsi, lorsque le module est accroché en position suspendue le long du bloc d'interfaçage 52 les contacts mâles et femelles de l'ensemble de contacts à piston entrent en contact les uns avec les autres et établissent ainsi une connexion électrique entre le module électronique et le câblage de l'aéronef non représenté sur les Figures.

Comme représenté sur les Figures 1 et 3, un système de refroidissement du ou des modules électroniques destinés à être connectés au bloc d'interfaçage 50 est prévu.

Dans l'exemple décrit on considère qu'un module 80 est connecté au bloc 50 (interface multifonction).

Ce système comprend les caissons transversaux agencés dans le cadre, tels que les caissons 30 et 32 sur la Figure 3, et qui définissent des canaux pour la circulation du fluide de refroidissement.

Ce fluide est, dans l'exemple de réalisation, de l'air.

Comme représenté sur la Figure 3, le caisson 32 forme une unité d'injection du fluide de refroidissement dans le module électronique comme illustré par les flèches repérées par la référence 1 (ventilation ou soufflage d'air froid), tandis que le caisson 30 constitue une unité d'aspiration du fluide ayant servi à refroidir le module électronique comme illustré par les flèches référencées A (aspiration ou évacuation d'air chaud).

Comme représenté sur la Figure 1, les caissons présentent une ouverture sous la forme d'une fente rectangulaire 30a, 32a, 34a, 36a, 38a et 40a qui s'étend suivant sensiblement toute la largeur du cadre.

Le bloc d'interfaçage 50 qui est fixé contre les montants transversaux du cadre vient obturer la fente localement sur toute la largeur du bloc (voir fentes 30a et 32a sur la Figure 3) et comporte des orifices traversant les bords ou ailes du bloc dans les portions de ceux-ci qui sont situées en vis-à-vis de la fente ouverte du caisson.

Plus particulièrement, comme représenté en section transversale sur la Figure 3, un conduit s'étend de part et d'autre de chaque bord du bloc d'interfaçage afin de canaliser l'écoulement de fluide traversant ledit bloc.

Ainsi, le bord 56 du bloc comporte un conduit 55 traversant ledit bord dans son épaisseur et permettant au fluide de refroidissement de passer du canal 44 au module électronique 80, tandis que le bord 54 du bloc comprend un conduit 57 permettant au fluide de refroidissement ayant circulé dans le module électronique et ayant rempli sa fonction de refroidissement d'être évacué dans le canal 42.

On notera que chacun des conduits 55 et 57 présente une extrémité débouchante qui fait saillie à l'intérieur de chacun des canaux/caissons 44 et 42.

Le bloc d'interfaçage 50 comprend également, de façon non représentée sur la Figure 3, mais représenté sur la Figure 2, deux autres conduits 59 et 61 situés en arrière plan des conduits respectifs 55 et 57 et espacés de ces derniers.

On notera que le nombre de conduits du bloc d'interfaçage dépend de la largeur de celui-ci, ainsi que des besoins de dissipation thermique.

Selon une variante non représentée, le système de climatisation comprend une unité d'injection d'un fluide, qui est par exemple de l'air, dans le module électronique, par exemple pour le refroidir, et le module comporte des ouvertures/orifices naturels ou non pour évacuer l'air chaud. Dans ce cas, il n'y a pas d'unité d'aspiration ou d'évacuation de l'air chaud dans le cadre.

Le module électronique 80 représenté sur la Figure 3 comporte une partie frontale de module 80a qui est pourvue d'une interface de connexion électrique complémentaire lui permettant de coopérer avec l'interface de connexion électrique présente dans la partie 52 du bloc d'interfaçage 50. Le module comporte également une interface de refroidissement complémentaire pour coopérer avec chacune des unités d'injection 44 et d'aspiration 42 du système de refroidissement.

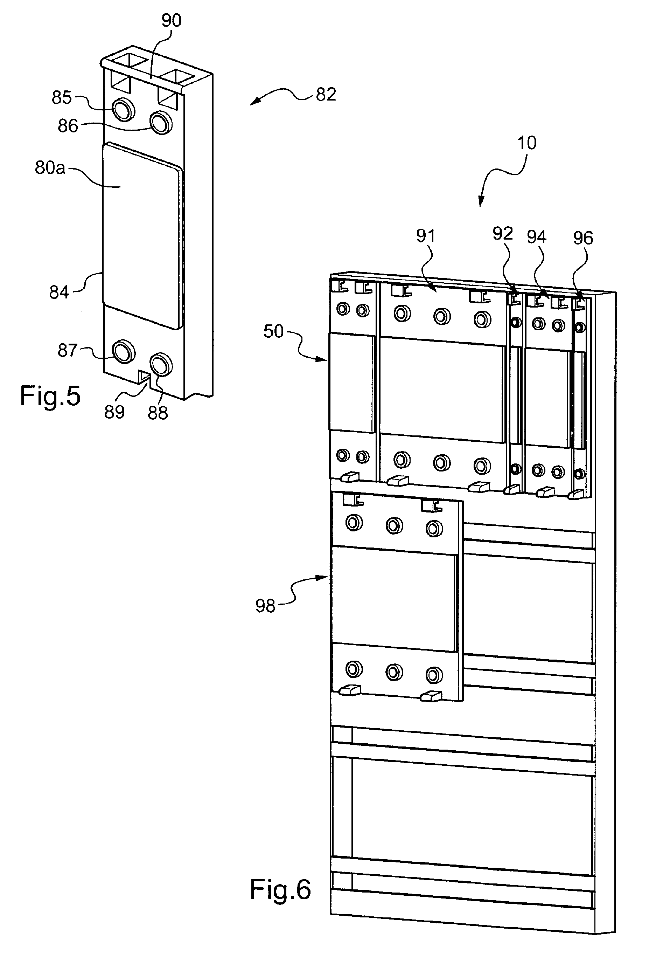

Cette partie de module 80a dédiée à ces interfaces peut faire partie intégrante du module ou faire partie d'un bloc d'interfaçage séparé 82 comme illustré sur la Figure 5.

Le module est par exemple fixé par vis au bloc 82 sur sa périphérie.

Ce bloc 82 a une forme sensiblement parallélépipédique comportant dans une partie centrale 84 qui est située en vis-à-vis de la partie centrale 52 du bloc 50 sur la Figure 3 et qui comporte l'interface de connexion électrique complémentaire de celle de la partie 52.

Le bloc d'interfaçage 82 comporte également, de part et d'autre de la partie centrale 84, deux portions comportant chacune des conduits dont une extrémité saillante débouche par rapport à la partie frontale 80a et coopère avec les extrémités débouchantes en vis-à-vis des conduits 55 et 57 du bloc d'interfaçage 50 (Figure 3).

Le bloc 82 comprend ainsi, en position haute, deux conduits 85 et 86 espacés l'un de l'autre et, en position basse, deux conduits 87 et 88 avec le même espacement, cet espacement correspondant à celui des conduits agencés sur le bloc d'interfaçage 50.

On notera que les conduits 87 et 88 permettent d'amener le fluide de refroidissement à l'intérieur du module électronique 80, tandis que les conduits 85 et 86 permettent d'évacuer, par aspiration, le fluide ayant servi à refroidir le module,

Lorsque le fluide du système de climatisation est un liquide les conduits d'amenée de fluide et d'évacuation de fluide du bloc d'interfaçage 50 et du bloc d'interfaçage 82 (par exemple les conduits 55 et 88) sont équipés chacun d'un connecteur fluidique à connexion et déconnexion rapide. Ces connecteurs sont par exemple soudés ou vissés sur les conduits avec une partie mâle d'un côté et une partie femelle de l'autre.

Un tel type de connecteur fluidique (non représenté sur les figures) est par exemple commercialisé par la société STAUBLI.

On notera qu'en raison de l'accrochage par suspension du module celui-ci est maintenu en contact contre la surface du bloc d'interfaçage sous l'action du poids du module.

Le poids du module combiné au mode de fixation du module sur le cadre contribue fortement à l'étanchéité de la connexion fluidique au niveau des conduits d'amenée ou d'évacuation.

En outre, un joint d'étanchéité (non représenté sur les figures) est disposé entre les blocs d'interfaçage et, plus particulièrement, entre les deux parois latérales en vis-à-vis des blocs adjacents pris deux à deux. Le joint est par exemple fixé à l'une des parois latérales et est du type joint «virgule ».

La Figure 6 illustre le cadre 10 de la Figure 1 sur lequel sont fixés plusieurs blocs d'interfaçage de cadre 50, 91, 92, 94, 96 et 98. Les blocs 91 et suivants comportent les mêmes caractéristiques que celles du bloc 50.

Les surfaces frontales de tous les blocs sont toutes situées dans un même plan vertical qui sert de plan commun de référence et d'interfaçage pour tous les modules devant s'interfacer avec ces blocs.

Comme représenté sur la Figure 6, les blocs d'interfaçage ont des largeurs différentes et le nombre de conduits/orifices pour la connexion au système de refroidissement varie en fonction de ces largeurs.

De façon générale, le nombre de conduits augmente avec la largeur du bloc dans la mesure où cette dernière est liée à la largeur du ou des modules électroniques qui vont s'interfacer avec le bloc et donc est liée aux besoins de dissipation thermique.

On trouve ainsi des blocs d'interfaçage comportant un seul conduit d'amenée et un seul conduit d'évacuation de fluide et des blocs qui en comportent trois de chaque type.

Toutefois, le nombre de conduits/orifices peut être supérieur à celui représenté sur la Figure 6.

Comme représenté sur les Figures, l'ensemble de fixation et de connexion électrique selon l'invention comprend, dans sa configuration minimale, un cadre tel que le cadre 10 de la Figure 3 et un module électronique 80, ce dernier étant accroché audit cadre.

Plus particulièrement, le module électronique 80 est accroché au bloc d'interfaçage 50 qui est lui-même fixé au cadre 10 (Figure 3).

Le module est accroché au bloc d'interfaçage par l'intermédiaire d'une liaison articulée, par exemple, autour d'une liaison pivot.

Le système d'accrochage du module est prévu en deux parties, l'une étant attenante au module et l'autre au bloc d'interfaçage.

Plus particulièrement, la face frontale de la partie frontale 80a du module s'étend entre deux extrémités opposées 80b et 80c qui définissent une dimension correspondant à la hauteur du module lorsque celui-ci est agencé contre le cadre vertical.

On notera que le module comporte une face opposée dite arrière 80d qui s'étend entre deux extrémités opposées suivant la hauteur, 80e et 80f, la hauteur de la face arrière étant inférieure à celle de la face avant.

En outre, la dimension (profondeur) du module entre les deux faces opposées 80a et 80d qui s'étend sur une perpendiculaire à la surface frontale 50a du bloc d'interfaçage est généralement inférieure à la hauteur maximale du bloc, voire même à la hauteur minimale.

Cette condition assure un maintien mécanique stable du module en position suspendue.

A titre d'exemple, la hauteur maximale du module est de 329mm, la hauteur minimale est de 282mm et la profondeur est de 222 mm.

Les dimensions du module ont par exemple été choisies afin d'intégrer dans ce module une ou plusieurs cartes électroniques de dimension standardisée 6U et de 160mm de longueur (profondeur).

La partie du système d'accrochage du module est disposée au voisinage de l'extrémité supérieure 80b et la partie complémentaire du bloc est disposée à l'extrémité supérieure du bloc d'interfaçage 50, au niveau du bord 54 et au-delà du conduit 57.

Comme représenté sur les Figures 1, 2, 3, et 5 le système d'accrochage comprend, sur le module, par exemple, au moins un élément formant pivot 90 et, sur la surface frontale du bloc d'interfaçage, un ou plusieurs éléments de réception et de retenue de l'élément formant pivot et, par exemple, un ou plusieurs crochets recourbés en direction de la surface frontale du bloc 50.

Par exemple, comme représenté sur les Figures 1, 2 et 5, l'élément formant pivot 90 prend la forme d'une barre parallèle à la largeur du module et qui est ici disposée horizontalement, tandis que deux crochets 92a et 92b sont fixés sur la surface 50a.

Selon une variante, l'élément 90 peut être constitué de deux barres formant pivots, espacées l'une de l'autre et disposées en vis-à-vis des deux organes de réception et de retenue 92a et 92b.

Selon une autre variante, le bloc d'interfaçage ou le module comprend un seul crochet qui est destiné à coopérer avec une barre unique 90.

On notera que le nombre d'éléments de fixation peut varier en fonction de la largeur du bloc d'interfaçage du module et peut ainsi être réduit à un lorsque cette largeur est réduite, comme pour les blocs 92 et 96 de la Figure 6.

Toutefois, lorsque la largeur du bloc d'interfaçage augmente comme c'est le cas pour les blocs 91 et 98 de la Figure 6, le nombre d'éléments de fixation ne varie pas, seul l'écartement entre ces derniers augmente.

Toutefois, si la largeur des blocs d'interfaçage augmente de façon significative, il peut être envisagé d'ajouter un ou plusieurs organes de fixation supplémentaires pour des raisons de tenue mécanique par rapport à la charge qui doit être supportée.

On notera par ailleurs que le système d'accrochage qui vient d'être décrit peut être inversé en ce sens que l'élément formant pivot 90 est agencé sur le bloc d'interfaçage 50, tandis que le ou les organes de retenue sont agencés sur le module,

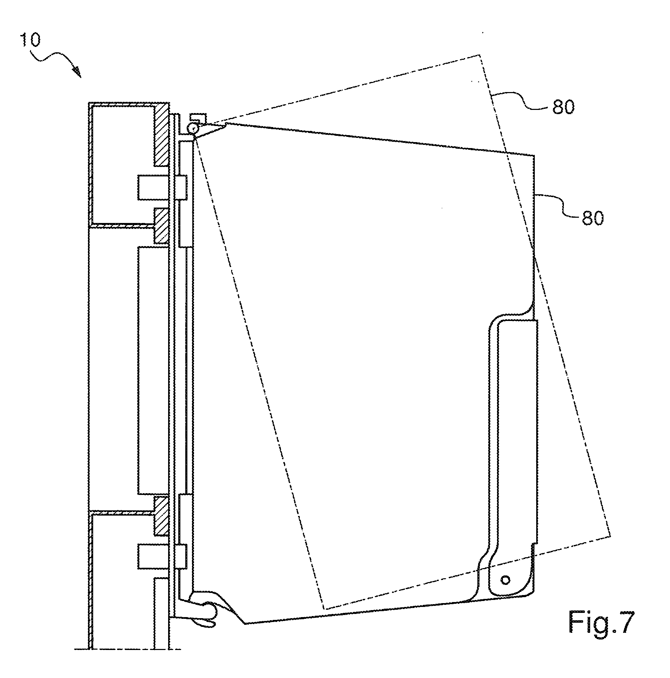

On notera que d'autres systèmes d'accrochage peuvent être utilisés pour suspendre le module au bloc d'interfaçage (interface verticale). La Figure 7 illustre le mouvement nécessaire pour l'installation d'un module électronique sur le cadre.

Pour installer le module électronique il faut amener ce dernier au voisinage du bloc d'interfaçage approprié en positionnant l'organe d'accrochage du module légèrement au-dessus de l'organe d'accrochage complémentaire dudit bloc d'interfaçage, dans la position légèrement inclinée illustrée en pointillés sur la Figure 7. On abaisse ensuite le module afin d'engager l'organe d'accrochage du module avec l'organe d'accrochage complémentaire du bloc pour former l'articulation et ensuite faire pivoter le module afin d'adopter la position illustrée en traits pleins sur la Figure 7. Le pivot en partie haute du module assure un guidage précis du module au moment de sa rotation par rapport au cadre.

Par ailleurs, la liaison pivot entre le module et le bloc assure le positionnement horizontal et vertical du module sans avoir recours à trois plans distincts comme dans l'art antérieur.

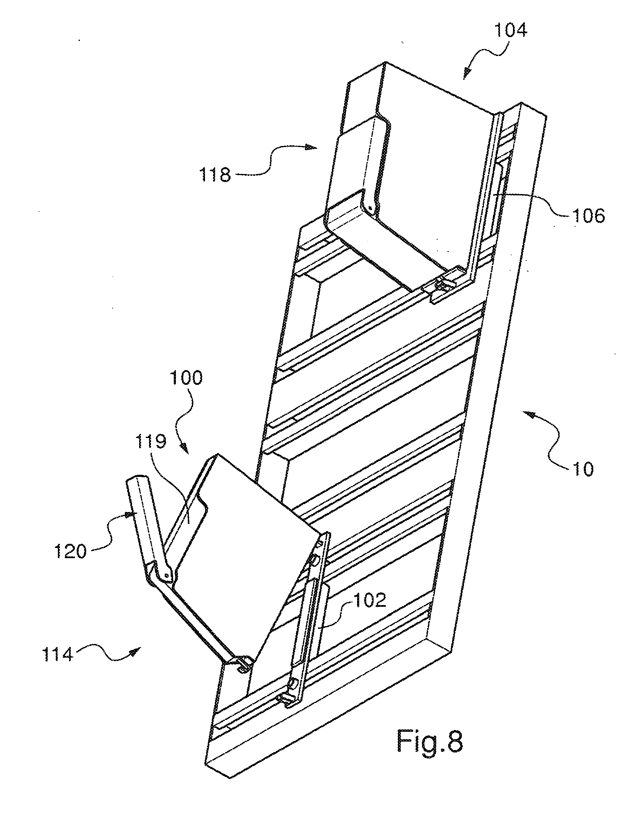

La Figure 8 illustre suivant une perspective vue par en-dessous le montage d'un module électronique 100 sur un bloc d'interfaçage 102 déjà fixé au cadre 10.

On a également représenté sur cette Figure un module 104 plus large que le module 100 et déjà installé en position sur son bloc d'interfaçage correspondant 106.

Ainsi accroché, le module électronique est suspendu au bloc d'interfaçage correspondant et la surface frontale du module est en contact avec la surface frontale 50a du bloc d'interfaçage afin d'assurer la coopération des interfaces de connexion électrique et thermique respectives.

Le nouvel ensemble de fixation et de connexion selon l'invention permet ainsi de fixer et de connecter plus facilement qu'auparavant un module électronique à une installation électrique existante et par exemple à un câblage d'aéronef.

L'ensemble occupe un encombrement relativement réduit par rapport à l'état de la technique et la maintenance des modules électroniques fixés au cadre est simplifiée.

On notera que l'épaisseur ou la profondeur (dimension suivant l'axe X sur la Figure 3) d'un meuble de l'état de la technique est par exemple de l'ordre de 400 mm, alors que celle de l'ensemble selon l'invention est de l'ordre de 300mm.

La réalisation d'un bloc d'interfaçage comprenant plusieurs types d'interface différents par exemple deux ou trois types (électrique, mécanique et thermique) et donc assurant plusieurs fonctions présente de nombreux avantages, à savoir :
- diminution du nombre de pièces de l'ensemble et donc réduction de la masse embarquée, facilité d'assemblage, réduction des coûts... ;
- concentration de fonctions complexes sur une seule pièce et, de ce fait, les pièces adjacentes (cadre, capotage du module...) peuvent être optimisées (plus simples, plus légères, moins chères à fabriquer...) ;
- possibilité de standardisation d'une pièce complexe.

Par ailleurs, des moyens de verrouillage du module dans sa position suspendue sont prévus.

Ces moyens de verrouillage sont composés de deux parties, une partie attenante au bloc d'interfaçage et l'autre partie attenante au module correspondant.

Comme représenté sur la Figure 3, les moyens de verrouillage du bloc d'interfaçage sont agencés en partie basse de celui-ci (sur le bord 56) et les moyens de verrouillage du module sont agencés à proximité de l'extrémité basse 80c.

Les moyens de verrouillage comprennent par exemple un crochet 110 lié au module 80 et qui coopère avec un organe de retenue 112 solidaire de la surface frontale 50a du bloc d'interfaçage (Figures 2 et 3).

L'organe de retenue 112 est par exemple réalisé sous la forme de deux bras 112a, 112b s'étendant à partir du bord 56 du bloc et dont les extrémités libres sont reliées entre elles par une tige 112c perpendiculaire aux bras (Figure 2).

On notera que le bloc 82 de la Figure 5 prévoit un dégagement 89 pour le passage du crochet.

Ce verrouillage du module en position suspendue permet de s'assurer que celui-ci ne s'écartera pas du cadre par suite de mouvements intempestifs ou de vibrations et qu'ainsi la connexion électrique ne sera pas interrompue, de même que la circulation du fluide de refroidissement.

On notera que les moyens de verrouillage comportent une biellette 114 agencée sous le module et qui permet d'actionner le déploiement ou la rétractation du crochet, jouant ainsi le rôle de gâchette grâce à l'actionnement d'un bras ou levier d'actionnement 116 qui constitue un organe de préhension (poignée) pour un utilisateur. Le mécanisme d'actionnement à gâchette du crochet est connu en soi et ne sera donc pas davantage décrit.

Les sociétés SOUTCHO et PINET fournissent des systèmes de verrouillage à gâchette. On notera que de tels systèmes peuvent en outre comporter des fonctionnalités supplémentaires du type, rattrapage de jeu et/ou gestion d'effort de retenue, électrique...

Cet organe de préhension 116 est relié aux moyens de verrouillage précédemment décrits et est actionnable entre une première position verrouillée dans laquelle l'organe est disposé de façon repliée contre le module, comme représenté en traits pleins sur la Figure 3 (voir également la poignée 118 en position repliée sur la Figure 8), et une position déployée dans laquelle l'organe est écarté du module (voir également la poignée 120 sur la Figure 8).

Dans la première position 116(a) où l'organe est replié contre le module grâce à une découpe adaptée de ce dernier, le crochet 110 du mécanisme à gâchette coopère avec l'organe de retenue 112, verrouillant ainsi le module en position.

On notera que l'organe 116 a une forme générale longitudinale et une section transversale par exemple en forme de U dont l'intérieur est en vis-à-vis du module et dont l'écartement entre les bras du U est légèrement inférieur à la largeur du module. Deux évidements, dont un référencé 117 est représenté sur l'une des parois extérieures du module (Figure 3), l'autre étant symétrique et aménagé sur la paroi extérieure opposée du module (évidement 119 du module 100 de la Figure 8), sont prévus pour accueillir les bras de la section en U de l'organe en position de rangement 116 (a).

Dans la position 116(b) représentée sur la Figure 3 où l'organe d'actionnement est écarté du module, la biellette 114 d'actionnement du crochet tire sur ce dernier qui est alors désengagé de l'organe de retenue 112 et libère ainsi le module de sa position verrouillée.

On notera que lorsque l'organe d'actionnement 116 sur la Figure 3 ou 120 sur la Figure 8 est écarté suivant une direction perpendiculaire à la surface frontale du bloc d'interfaçage, alors l'organe dans cette position sert de témoin visuel pour un observateur qui sait que le module est en position non verrouillée. L'observateur est ainsi informé que le module n'est pas correctement positionné et que son bon fonctionnement n'est pas assuré.

Il convient alors de prendre les mesures adaptées soit pour le remettre en position verrouillée ou pour le retirer de son emplacement.

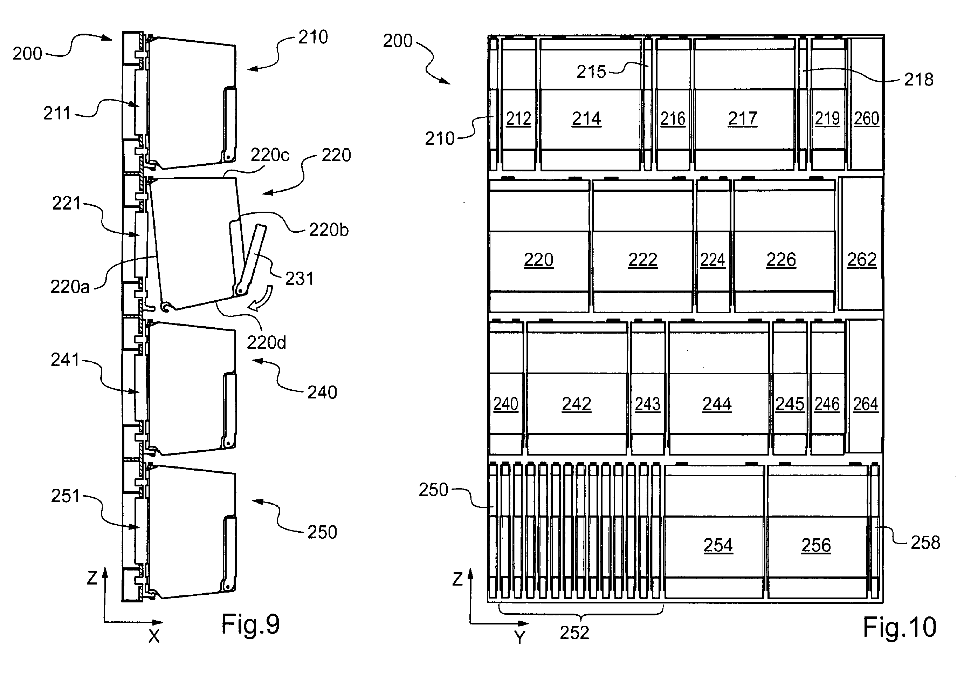

On a représenté sur la Figure 9 une vue en section transversal d'un ensemble de fixation et de connexion électrique selon l'invention.

Cet ensemble comprend un cadre 200 qui forme une structure analogue au cadre 10 des Figures précédentes (cette structure s'apparente à un tableau) et sur laquelle sont rapportés de manière suspendue plusieurs modules électroniques dont seuls certains sont représentés, à savoir, les modules 210, 220, 240 et 250 qui sont disposés les uns au-dessus des autres.

On notera que pour agencer quatre modules les uns au-dessus des autres le cadre 200 comporte un montant transversal supplémentaire par rapport au cadre 10 de la Figure 1.

La structure interne du cadre est identique à celle illustrée et décrite en référence aux Figures précédentes et des blocs d'interfaçage 211, 221, 241 et 251 identiques au bloc 50 de la Figure 3 sont fixés sur la face frontale du cadre pour permettre l'interfaçage mécanique et électrique des modules électroniques sur une interface verticale.

Le module 220 a été représenté en position légèrement inclinée afin d'illustrer la position adoptée lors de la mise en place ou du retrait d'un module avec l'organe d'actionnement 231 écarté.

Les modules qui sont vus en section transversale ont une forme identique mais leur largeur peut différer comme illustré sur la Figure 10.

Le module 220 comporte une face frontale 220a et une face arrière opposée 220b, la face frontale étant destinée à venir en contact avec la surface frontale du bloc d'interfaçage 221 en vis-à-vis.

Le module 220 comporte également deux faces supérieure et inférieure, respectivement notées 220c et 220d, qui forment chacune une pente pour relier la face frontale à la face arrière dans la mesure où cette dernière est de dimension inférieure à la dimension de la face frontale.

Cette légère pente de l'ordre de quelques degrés permet au module d'être pivoté vers le haut autour de son axe de pivotement supérieur sans risquer d'être gêné dans ce mouvement par le module situé au-dessus (module 210 sur la Figure 9).

On notera par ailleurs que la dimension des modules électroniques suivant l'axe des X, c'est-à-dire dans une direction perpendiculaire à la surface frontale des blocs d'interfaçage, surface incluant l'axe des Z (cette dimension correspond à l'épaisseur ou à la profondeur du module), est inférieure à la dimension du module suivant l'axe des Z lorsque le module est disposé verticalement comme sur la Figure 9 (cette dimension est appelée hauteur du module).

Cette relation dimensionnelle assure le maintien en position suspendue des modules sur le cadre de façon stable, sans qu'il n'y ait de risque d'exercer un couple de forces trop élevé sur le cadre en raison d'un bras de levier trop important.

Comme brièvement évoqué ci-dessus, la Figure 10 illustre en vue de face le cadre 200 sur lequel sont montés une pluralité de modules électroniques de largeurs variables, répartis les uns au-dessus des autres suivant plusieurs rangées. L'ensemble de fixation et de connexion de modules électroniques selon l'invention comporte une première rangée supérieure de modules électroniques 210, 212, 214, 215, 216, 217, 218 et 219 présentant des largeurs variables.

L'ensemble comporte également une rangée immédiatement inférieure comprenant les modules électroniques 220, 222, 224 et 226.

Sur une rangée encore inférieure l'ensemble comprend les modules électroniques 240, 242, 243, 244, 245 et 246.

Enfin, sur la rangée la plus inférieure l'ensemble comprend le module électronique 250, une pluralité de modules électroniques de faible largeur regroupés sous la référence 252 et des modules électroniques de plus grande largeur 254 et 256, ainsi qu'un dernier module électronique 258 de faible largeur.

Pour permettre la fixation et la connexion électrique de ces modules dans un même plan vertical le cadre est préalablement équipé de blocs d'interfaçage situés à des cotes verticales différentes et, pour une même cote, à des positions spatiales différentes le long de l'axe Y. Chacun de ces blocs comporte un système d'accrochage de modules et une interface de connexion électrique,

Par ailleurs, l'ensemble de la Figure 10 comporte également sur les trois premières rangées en partant du haut des éléments référencés 260, 262 et 264 de largeur variable et qui constituent des obturateurs afin d'obturer les emplacements non utilisés sur le cadre.

A titre d'exemple, ces obturateurs se fixent directement sur le cadre et ont notamment pour fonction de fermer de façon étanche la fente de chacun des caissons de ventilation et d'aspiration en vis-à-vis de laquelle ils sont disposés.

Ces éléments d'obturation peuvent prendre la forme de blocs/plaques sensiblement plans.

Alternativement, les éléments d'obturation peuvent être fixés directement (par exemple par clipsage) aux blocs d'interfaçage du cadre, sur les orifices des conduits débouchants d'amenée et d'évacuation de fluide, à la façon de caches de protection ou de bouchons (exemple en plastique).

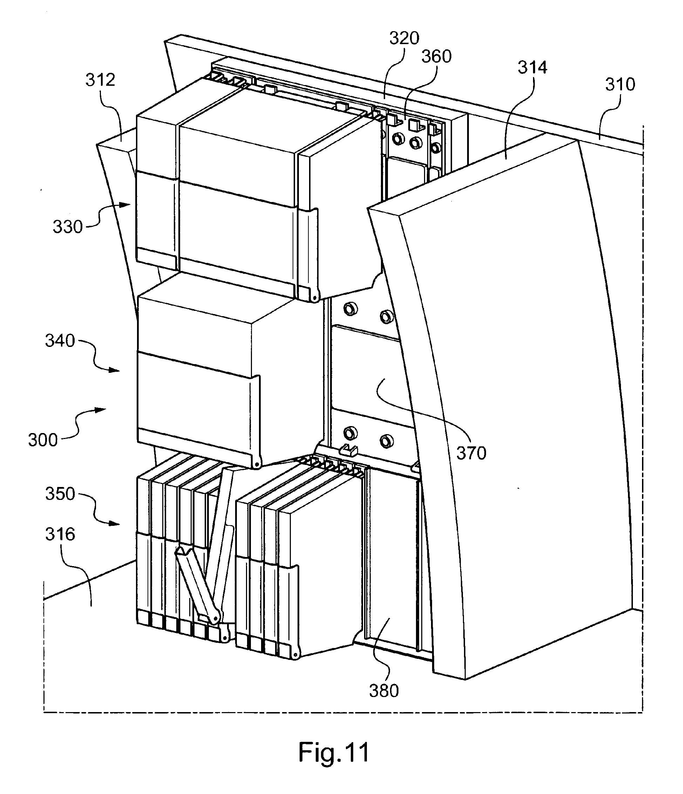

On a représenté sur la Figure 11 l'implantation dans un aéronef d'un ensemble modulaire 300 selon l'invention.

Cet ensemble est disposé contre une structure 310 de l'aéronef (paroi latérale) entre deux parois verticales 312 et 314, solidaires de la structure 310 et qui s'étendent perpendiculairement à partir de celle-ci vers l'intérieur de l'aéronef.

L'ensemble comprend un cadre 320, analogue au cadre précédemment décrit, et qui est disposé contre la paroi 310 de l'aéronef.

Ce cadre est par exemple fixé contre cette paroi par exemple par l'intermédiaire de biellettes qui assurent un réglage en position optimal tout en compensant la forme circulaire de la cabine de l'aéronef. Tout comme les ensembles précédemment décrits, le cadre 320 est équipé d'une pluralité de blocs d'interfaçage comportant chacun des interfaces mécaniques pour l'accrochage de modules électroniques, des interfaces de connexion électrique pour la connexion électrique avec les modules et des interfaces thermiques pour le refroidissement des modules.

L'ensemble 300 comporte ainsi une pluralité de modules électroniques agencés horizontalement et verticalement suivant plusieurs rangées disposées les unes au-dessus des autres, chaque rangée horizontale comportant plusieurs modules disposés les uns à côté des autres.

On distingue ici trois rangées, chaque rangée comportant une pluralité de modules électroniques représentés par la référence 330 pour la première rangée supérieure, 340 pour la deuxième rangée immédiatement inférieure et 350 pour la rangée la plus basse, près du plancher 316.

On notera que sur la rangée la plus basse l'un des modules électroniques est en position pivotée qui correspond à une mise en place ou à un retrait, la poignée d'actionnement du module étant écartée de ce dernier.

Un espace vertical de dégagement suffisant est prévu entre les modules les plus bas 350 et le plancher 316 pour permette leur mise en place et leur retrait par pivotement.

On notera en outre que sur les deux rangées les plus hautes deux blocs d'interfaçage 360 et 370 sont respectivement fixés au cadre en prévision de la réception d'un module électronique sur chacun d'eux.

En outre, sur la dernière rangée la plus basse l'ensemble comporte également un élément d'obturation 380 disposé à côté des modules électroniques.

Cet élément est bien entendu amovible et peut être remplacé par un bloc d'interfaçage lorsque l'ensemble doit être équipé de modules électroniques supplémentaires. Selon une variante, un tel élément peut être fixé sur un bloc d'interfaçage à la façon d'un cache de protection.

On constate ainsi que les ensembles de fixation et de connexion selon l'invention offrent une modularité particulièrement avantageuse ainsi qu'une grande ergonomie, tant pour le montage que pour le démontage des modules électroniques et des blocs d'interfaçage.

De façon non représentée, le cadre est raccordé par l'arrière au câblage de l'aéronef, plus particulièrement les parties centrales des blocs d'interfaçage où sont situées les interfaces de connexion électrique sont raccordées à une pluralité de faisceaux de câbles équipés de connecteurs par l'intermédiaire de moyens de raccordement électriques adaptés des blocs d'interfaçage.

On notera en outre que le cadre 320, et plus particulièrement les caissons du système de refroidissement, sont également raccordés à un circuit de refroidissement/ventilation existant à bord l'aéronef.

## Revendications

1. Ensemble modulaire de fixation de modules électroniques embarqués à bord d'un aéronef, **caractérisé en ce qu'**il comprend :
- un cadre (10) sensiblement plan comprenant au moins deux montants longitudinaux (12, 14) reliés entre eux par une pluralité de montants transversaux (32, 34, 36, 38) ayant une surface frontale verticale sensiblement plane, comprenant plusieurs interfaces de fixation mécanique destinées à fixer mécaniquement chacune un module électronique et plusieurs interfaces de connexion électrique destinées à établir chacune une connexion électrique avec un module électronique,
- au moins un module électronique (80) comprenant, sur sa face arrière, une interface de fixation mécanique et qui est accroché à la surface frontale du cadre en position suspendue par coopération de l'interface de fixation mécanique dudit au moins un module électronique avec l'une des interfaces de fixation mécanique du cadre et une interface de connexion électrique coopérant avec l'une des interfaces de connexion électrique du cadre afin d'établir une connexion électrique.

2. Ensemble selon la revendication 1, **caractérisé en ce qu'**il comporte des moyens de verrouillage (110, 112) du module en position suspendue.

3. Ensemble selon la revendication 2, **caractérisé en ce qu'**un organe d'actionnement (116) relié aux moyens de verrouillage est prévu sur le module et est actionnable entre une position verrouillée (116(a)) dans laquelle l'organe est disposé contre le module et une position déverrouillée (116(b)) dans laquelle l'organe est écarté du module.

4. Ensemble selon l'une des revendications précédentes, **caractérisé en ce que** le module est accroché à la surface frontale du cadre par l'intermédiaire d'un système d'accrochage (90, 92a, 92b) formant une liaison articulée.

5. Ensemble selon l'une des revendications précédentes, **caractérisé en ce qu'**il comprend un système de climatisation du module électronique.

6. Ensemble selon la revendication 5, **caractérisé en ce que** le système de climatisation comprend, fixées au cadre (10), une unité d'injection (44, 55) d'un fluide dans le module et une unité d'aspiration (52, 57) du fluide ayant été injecté dans le module, et/ou une plusieurs ouvertures dans le module pour l'évacuation du fluide injecté, le module comportant une interface complémentaire pour coopérer avec au moins l'unité d'injection.

7. Ensemble selon l'une des revendications précédentes, **caractérisé en ce que** le cadre (10) comprend un bloc d'interfaçage (50) avec ledit au moins un module (80) qui possède la surface frontale verticale sensiblement plane, le module étant accroché à la surface frontale verticale du bloc d'interfaçage du cadre.

8. Ensemble selon l'une des revendications précédentes, **caractérisé en ce qu'**il comprend une pluralité de systèmes d'accrochage de module qui sont agencés, d'une part, horizontalement pour pouvoir suspendre plusieurs modules les uns à côté des autres suivant une disposition horizontale formant une rangée et, d'autre part, à des cotes verticales différentes de façon à pouvoir suspendre plusieurs rangées de modules les unes au-dessus des autres.

9. Cadre de fixation (10) de modules électroniques embarqués à bord d'un aéronef, **caractérisé en ce qu'**il est sensiblement plan et **en ce qu'**il comporte :
- au moins deux montants longitudinaux (12, 14) reliés entre eux par une pluralité de montants transversaux (32, 34, 36, 38) ;
- une surface frontale sensiblement plane,
- plusieurs interfaces de fixation mécanique sur la surface frontale destinées chacune à l'accrochage en position suspendue d'un module électronique embarqué à bord de l'aéronef, et
- plusieurs interfaces de connexion électrique destinées à établir chacune une connexion avec un module électronique.

10. Cadre selon la revendication 9, **caractérisé en ce qu'**il comporte un système de climatisation du module électronique comprenant une unité d'injection (44, 55) d'un fluide destinée à injecter un fluide dans le module et éventuellement une unité d'aspiration (52, 57) du fluide destinée à aspirer le fluide injecté dans le module.

11. Module électronique (80) destiné à coopérer avec le cadre selon l'une des revendications 9 à 10, **caractérisé en ce que** ledit module comporte sur sa face arrière, une interface de fixation mécanique complémentaire de celle du cadre afin de pouvoir accrocher le module en position suspendue à la surface frontale dudit cadre et une interface de connexion électrique destinée à coopérer avec l'une des interfaces de connexion électrique du cadre selon la revendication 9 pour établir une connexion électrique.

12. Aéronef, **caractérisé en ce qu'**il comporte un ensemble modulaire de fixation selon l'une des revendications 1 à 8 ou un cadre de fixation (10) selon l'une des revendications 9 à 10.

## Patentansprüche

1. Modulare Anordnung zur Befestigung von an Bord eines Luftfahrzeugs befindlichen elektronischen Modulen, **dadurch gekennzeichnet, dass** sie umfasst:
- einen im Wesentlichen flachen Rahmen (10), mit wenigstens zwei Längsholmen (12, 14), die durch eine Vielzahl von Querholmen (32, 34, 36, 38), welche eine im Wesentlichen ebene vertikale Stirnseite aufweisen, untereinander verbunden sind, umfassend mehrere Schnittstellen zur mechanischen Befestigung, die dazu bestimmt sind, jeweils ein elektronisches Modul mechanisch zu befestigen, sowie mehrere Schnittstellen zur elektrischen Verbindung, die dazu bestimmt sind, jeweils eine elektrische Verbindung mit einem elektronischen Modul herzustellen,
- wenigstens ein elektronisches Modul (80), umfassend an seiner Rückseite eine Schnittstelle zur mechanischen Befestigung, die in hängender Position durch Zusammenwirken der Schnittstelle zur mechanischen Befestigung des wenigstens einen elektronischen Moduls mit einer der Schnittstellen zur mechanischen Befestigung des Rahmens an der Stirnseite des Rahmens eingehängt ist, und eine Schnittstelle zur elektrischen Verbindung umfasst, die mit einer der Schnittstellen zur elektrischen Verbindung des Rahmens zusammenwirkt, um eine elektrische Verbindung herzustellen.

2. Anordnung nach Anspruch 1, **dadurch gekennzeichnet, dass** sie Mittel zur Verriegelung (110, 112) des Moduls in hängender Position umfasst.

3. Anordnung nach Anspruch 2, **dadurch gekennzeichnet, dass** ein mit den Verrieglungsmitteln verbundenes Betätigungsorgan (116) an dem Modul vorgesehen ist und zwischen einer verriegelten Stellung (116(a)), in der das Organ an dem Modul angeordnet ist, und einer entriegelten Stellung (116(b)), in der das Organ von dem Modul entfernt ist, betätigbar ist.

4. Anordnung nach einem der vorhergehenden Ansprüche, **dadurch gekennzeichnet, dass** das Modul über ein Einhängesystem (90, 92a, 92b), das eine Gelenkverbindung bildet, an der Stirnseite des Rahmens eingehängt ist.

5. Anordnung nach einem der vorhergehenden Ansprüche, **dadurch gekennzeichnet, dass** sie ein System zur Klimatisierung des elektronischen Moduls umfasst.

6. Anordnung nach Anspruch 5, **dadurch gekennzeichnet, dass** das Klimatisierungssystem, an dem Rahmen (10) befestigt, eine Einheit zum Einleiten (44, 55) eines Fluids in das Modul sowie eine Einheit zum Absaugen (52, 57) des Fluids, das in das Modul eingeleitet wurde, und/oder eine oder mehrere Öffnungen in dem Modul zum Abführen des eingeleiteten Fluids umfasst, wobei das Modul eine ergänzende Schnittstelle umfasst, um mit wenigstens der Einleitungseinheit zusammenzuwirken.

7. Anordnung nach einem der vorhergehenden Ansprüche, **dadurch gekennzeichnet, dass** der Rahmen (10) einen Block zum Koppeln (50) mit dem wenigstens einen Modul (80) umfasst, der die im Wesentlichen ebene vertikale Stirnseite aufweist, wobei das Modul an der vertikalen Stirnseite des Kopplungsblocks des Rahmens eingehängt wird.

8. Anordnung nach einem der vorhergehenden Ansprüche, **dadurch gekennzeichnet, dass** sie eine Vielzahl von Moduleinhängesystemen umfasst, die einerseits horizontal angeordnet sind, um mehrere Module entsprechend einer eine Reihe bildenden horizontalen Anordnung nebeneinander aufhängen zu können, und andererseits in unterschiedlichen vertikalen Höhen angeordnet sind, um mehrere Modulreihen übereinander aufhängen zu können.

9. Rahmen zur Befestigung (10) von an Bord eines Luftfahrzeugs befindlichen elektronischen Modulen, **dadurch gekennzeichnet, dass** er im Wesentlichen eben ist und dass er umfasst:
- wenigstens zwei Längsholme (12, 14), die durch eine Vielzahl von Querholmen (32, 34, 36, 38) untereinander verbunden sind,
- eine im Wesentlichen ebene Stirnseite,
- mehrere Schnittstellen zur mechanischen Befestigung an der Stirnseite, die jeweils zum Einhängen eines an Bord des Luftfahrzeugs befindlichen elektronischen Moduls in hängender Position bestimmt sind, sowie
- mehrere Schnittstellen zur elektrischen Verbindung, die dazu bestimmt sind, jeweils eine Verbindung mit einem elektronischen Modul herzustellen.

10. Rahmen nach Anspruch 9, **dadurch gekennzeichnet, dass** er ein System zur Klimatisierung des elektronischen Moduls umfasst, das eine Einheit zum Einleiten (44, 55) eines Fluids, welche dazu bestimmt ist, ein Fluid in das Modul einzuleiten, sowie eventuell eine Einheit zum Absaugen (52, 57) des Fluids, welche dazu bestimmt ist, das in das Modul eingeleitete Fluid abzusaugen, umfasst.

11. Elektronisches Modul (80), das dazu bestimmt ist, mit dem Rahmen nach einem der Ansprüche 9 bis 10 zusammenzuwirken, **dadurch gekennzeichnet, dass** das Modul an seiner Rückseite eine Schnittstelle zur mechanischen Befestigung, welche zu derjenigen des Rahmens komplementär ausgebildet ist, um das Modul in hängender Position an der Stirnseite des Rahmens einhängen zu können, sowie eine Schnittstelle zur elektrischen Verbindung umfasst, die dazu bestimmt ist, mit einer der Schnittstellen zur elektrischen Verbindung des Rahmens nach Anspruch 9 zusammenzuwirken, um eine elektrische Verbindung herzustellen.

12. Luftfahrzeug, **dadurch gekennzeichnet, dass** es eine modulare Befestigungsanordnung nach einem der Ansprüche 1 bis 8 oder einen Befestigungsrahmen (10) nach einem der Ansprüche 9 bis 10 umfasst.

## Claims

1. Modular assembly for fastening electronic modules carried on board of an aircraft, **characterized in that** it comprises:
- a frame (10) more or less planar comprising at least two longitudinal frame members (12, 14) connected together through a plurality of transversal frame members (32, 34, 36, 38) having a vertical front surface more or less planar, comprising several mechanical fastening interfaces each intended for mechanically fastening an electronic module, and several electrical connection interfaces each intended for establishing an electrical connection with an electronic module,
- at least one electronic module (80) comprising on its rear side a mechanical fastening interface and which is attached to the front surface of the frame in suspended position via cooperation of the mechanical fastening interface of the said at least one electronic module with one of the mechanical fastening interfaces of the frame, and an electrical connection interface cooperating with one of the electrical connection interfaces of the frame so as to establish an electrical connection.

2. Assembly according to claim 1, **characterized in that** it comprises means for locking (110, 112) the module in suspended position.

3. Assembly according to claim 2, **characterized in that** an actuation component (116) connected to the locking means is provided on the module and may be actuated between a locked position (116(a)) in which the component is disposed against the module and an unlocked position (116(b)) in which the component is moved away from the module.

4. Assembly according to one of the preceding claims, **characterized in that** the module is attached to the front surface of the frame via an attachment system (90, 92a, 92b) forming an articulated link.

5. Assembly according to one of the preceding claims, **characterized in that** it comprises an air-conditioning system for the electronic module.

6. Assembly according to claim 5, **characterized in that** the air-conditioning system comprises, fastened to the frame (10), a unit for injection (44, 55) of a fluid into the module and a unit for suction (52, 57) of the fluid having been injected into the module, and/or several openings in the module for evacuation of the injected fluid, the module comprising a complementary interface for cooperating with at least one injection unit.

7. Assembly according to one of the preceding claims, **characterized in that** the frame (10) comprises a block (50) for interfacing with the said at least one module (80) which has the more or less planar vertical front surface, the module being attached to the vertical front surface of the interfacing block of the frame.

8. Assembly according to one of the preceding claims, **characterized in that** it comprises a plurality of module attachment systems which are arranged, on the one hand horizontally in order to be able to suspend several modules one next to the other according to a horizontal arrangement forming a row and, on the other hand at different vertical heights so as to be able to suspend several rows of modules one above the other.

9. Frame (10) for fastening electronic modules carried on board an aircraft, **characterized in that** it is more or less planar and comprises :
- at least two longitudinal frame members (12, 14) connected together through a plurality of vertical frame members (32, 34, 36, 38),
- a more or less planar front surface,
- several mechanical fastening interfaces on the front surface each intended for attaching in suspended position an electronic module carried on board the aircraft, and several electrical fastening interfaces each intended for establishing a connection with an electronic module.

10. Frame according to claim 9, **characterized in that** it comprises an air-conditioning system for the electronic module comprising a unit for injection (44, 55) of a fluid intended for injecting a fluid into the module and possibly a unit for suction (52, 57) of the fluid intended to suck up the fluid injected into the module.

11. Electronic module (80) intended to cooperate with the frame according to one of claims 9 to 10, **characterized in that** said module comprises on its rear side a mechanical fastening interface complementary to that of the frame in order to be able to attach the module in position suspended from the front surface of the said frame, and an electrical connection interface intended to cooperate with one of the electrical connection interfaces of the frame according to claim 9 in order to establish an electrical connection.

12. Aircraft, **characterized in that** it comprises a modular fastening assembly according to one of claims 1 to 8 or a fastening frame (10) according to one of claims 9 to 10.
